# EUROPEAN PATENT APPLICATION

(11) **EP 4 369 425 A1**
(43) Date of publication of application: **15.05.2024**
(21) Application number: 22837593.7
(22) Date of filing: 30.06.2022
(51) Int. Cl.: H01L 33/08, H01L 33/06, H01L 33/10, H01L 33/22, H01L 33/24, H01L 33/32

(54) **SEMICONDUCTOR LIGHT EMITTING ELEMENT AND METHOD FOR PRODUCING SEMICONDUCTOR LIGHT EMITTING ELEMENT**

(30) Priority: 08.07.2021 JP 2021113350; 08.07.2021 JP 2021113883
(71) Applicant: KOITO MANUFACTURING CO., LTD., Minato-ku, Tokyo, 108-8711 (JP)
(72) Inventor: KANAOKA, Hiroaki, Shizuoka-shi, Shizuoka 424-8764 (JP); NOMURA, Akihiro, Shizuoka-shi, Shizuoka 424-8764 (JP)
(74) Representative: Cabinet Beau de Loménie
(86) International application number: PCT/JP2022/026276
(87) International publication number: WO 2023/282177

(57) **Abstract**

A semiconductor light emitting element (10) includes a growth substrate (11), a plurality of columnar semiconductor layers (14 to 16) on the growth substrate (11), and an embedded layer (18) formed to cover the columnar semiconductor layer (14 to 16), in which a side surface reflection portion (17) configured to reflect at least a part of light emitted from the columnar semiconductor layer (14 to 16) is provided on a side surface of the columnar semiconductor layer (14 to 16).

## Description

### TECHNICAL FIELD

The present disclosure relates to a semiconductor light emitting element and a method for producing a semiconductor light emitting element, and more particularly, to a semiconductor light emitting element having a structure in which a plurality of columnar semiconductor layers are embedded in an embedded layer and a method for producing a semiconductor light emitting element.

### BACKGROUND ART

In recent years, a method for growing a crystal of a nitride-based semiconductor has rapidly progressed, and blue and green light emitting devices having high luminance using this material have been put into practical use. When a red light emitting element existing in the related art is combined with the blue light emitting element and the green light emitting element, all three primary colors of light are available, and a full-color display device can be implemented. That is, when all the three primary colors of light are mixed, white light can be obtained, and application to a lighting device is also possible.

In the semiconductor light emitting element used as a light source for illumination, it is desirable that high energy conversion efficiency and high light output can be realized in a high current density region, and it is desirable that the distribution characteristics of emitted light are stable. In order to solve this problem, Patent Literature 1 proposes a semiconductor light emitting element in which an n-type nanowire core, an active layer, and a p-type layer are grown on a growth substrate, a tunnel junction layer is formed on a side surface of the p-type layer, and is embedded by an n-type embedded layer.

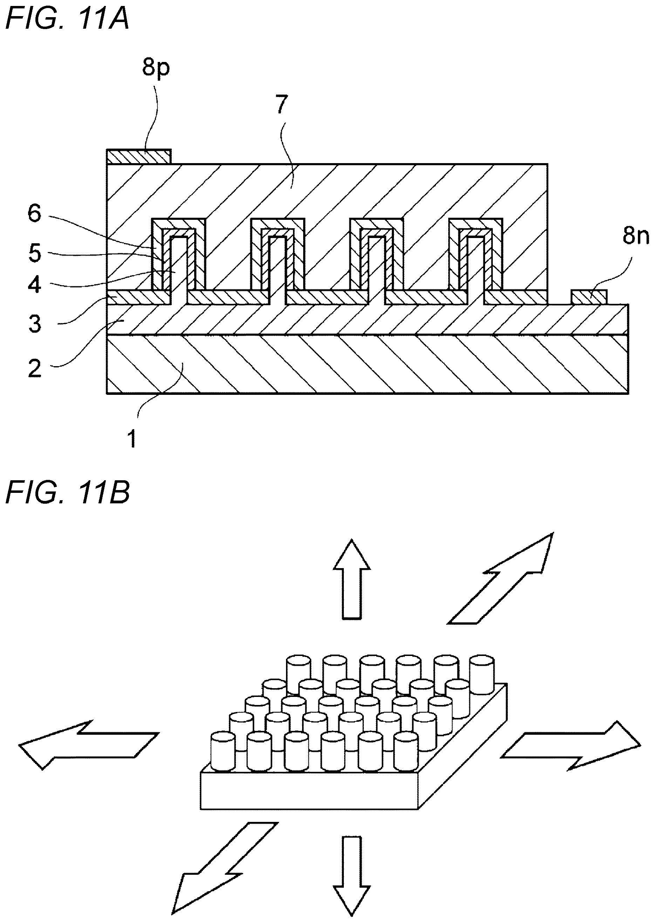

FIGS. 11A and 11B are schematic views illustrating a semiconductor light emitting element that has been proposed in the related art and that includes columnar semiconductor layers, FIG. 11A is a schematic cross-sectional view, and FIG. 11B is a schematic perspective view illustrating light extraction directions. As illustrated in FIG. 11A, the semiconductor light emitting element includes a growth substrate 1, an underlying layer 2, masks 3, nanowire layers 4, active layers 5, p-type layers 6, an embedded layer 7, a cathode electrode 8n, and an anode electrode 8p. Here, the nanowire layers 4, the active layers 5, and the p-type layers 6 are formed to stand at a predetermined angle with respect to a main surface of the growth substrate 1, and constitute columnar semiconductor layers each having a double hetero structure.

In such a semiconductor light emitting element, when a voltage is applied between the anode electrode 8p and the cathode electrode 8n, holes are injected from the embedded layer 7 into the p-type layer 6, electrons are injected from the underlying layer 2 into the nanowire layer 4, and light of a predetermined wavelength is emitted from the active layer 5 by radiative recombination. In such a semiconductor light emitting element, the number of crystal defects and threading dislocations generated in each semiconductor layer is smaller than those in the case where the active layer is formed on an entire surface of the growth substrate 1, and a high-quality crystal can be obtained. In addition, since the active layer has an m-plane which is a nonpolar plane along a side surface of the columnar semiconductor layer as a facet, external quantum efficiency in a high current density can be improved.

### CITATION LIST

### PATENT LITERATURE

Patent Literature 1: JP2020-077817A

### SUMMARY OF INVENTION

### TECHNICAL PROBLEM

However, in the related art, the active layer 5 is formed along the side surface of the columnar semiconductor layer, and the double hetero structure is also formed along the side surface. Therefore, as illustrated in FIG. 11B, the light emitted from the active layer 5 tends to be extracted in an in-plane direction rather than in a main surface direction. Such light extraction in the in-plane direction is not preferable for a surface-emitting type semiconductor light emitting element. In addition, light emitted from each columnar semiconductor layer may be absorbed by another columnar semiconductor layer while traveling in the plane, and there is a problem that it is difficult to improve the external quantum efficiency.

The present disclosure has been made in view of the above problems in the related art, and an object of the present disclosure is to provide a semiconductor light emitting element and a method for producing a semiconductor light emitting element capable of increasing an amount of light extracted in a main surface direction and a back surface direction even in a case of a semiconductor light emitting element having a columnar semiconductor layer.

### SOLUTION TO PROBLEM

In order to solve the above problem, a semiconductor light emitting element according to the present disclosure includes a growth substrate, a plurality of columnar semiconductor layers on the growth substrate, and an embedded layer formed to cover the columnar semiconductor layers, in which a side surface reflection portion configured to reflect at least a part of light emitted from the columnar semiconductor layer is provided on a side surface of the columnar semiconductor layer.

In such a semiconductor light emitting element according to the present disclosure, since the side surface reflection portion is formed on the side surface of the columnar semiconductor layer, a part of the light emitted from the columnar semiconductor layer is reflected in a direction perpendicular to the growth substrate, and it is possible to increase an amount of light extracted in the main surface direction.

According to an aspect of the present disclosure, the side surface reflection portion is a light reflection film in contact with a side surface of the columnar semiconductor layer.

According to an aspect of the present disclosure, the light reflection film is formed of a metal material containing any one of Al, Au, Ag, and Cr as a main component.

According to an aspect of the present disclosure, the light reflection film is formed of a semiconductor material having a band gap larger than a wavelength of the light, the light reflection film having an optical thickness larger than the wavelength of the light.

According to an aspect of the present disclosure, the light reflection film is a dielectric multilayer film containing any one of HfO₂, TiO₂, Ta₂O₅, Al₂O₃, SiO₂, and MgF₂.

According to an aspect of the present disclosure, the embedded layer is formed of a material having a refractive index different from that of each columnar semiconductor layer, the side surface of the columnar semiconductor layer has an inclined side surface inclined with respect to a main surface of the growth substrate, and the side surface reflection portion is formed of an interface between the inclined side surface and the embedded layer.

According to an aspect of the present disclosure, the light of the side surface reflection portion has a reflectivity in a range of 30% to 90%.

According to an aspect of the present disclosure, an upper surface reflection portion configured to reflect the light toward the growth substrate is formed on a surface of the embedded layer opposite to the growth substrate.

In order to solve the above problem, a method for producing a semiconductor light emitting element according to the present disclosure includes: a columnar semiconductor growth step of forming a plurality of columnar semiconductor layers on a growth substrate; a side surface reflection portion formation step of forming a side surface reflection portion on a side surface of the columnar semiconductor layer; and an embedded layer formation step of forming an embedded layer to cover the columnar semiconductor layer.

In order to solve the above problem, a semiconductor light emitting element according to the present disclosure includes: a growth substrate; a plurality of columnar semiconductor layers formed on the growth substrate; and an embedded layer covering each of the columnar semiconductor layers, in which the columnar semiconductor layer includes a nanowire layer, an active layer disposed on an outer periphery of the nanowire layer, and a p-type layer disposed on an outer periphery of the active layer, and a side surface of the active layer is inclined with respect to a main surface of the growth substrate.

In such a semiconductor light emitting element according to the present disclosure, since the side surface of the active layer is inclined with respect to the main surface of the growth substrate, light emitted from the active layer is extracted obliquely upward of the growth substrate, and it is possible to increase an amount of light extracted in the main surface direction.

According to an aspect of the present disclosure, the nanowire layer includes an inclined side surface portion which is a side surface inclined with respect to the main surface.

According to an aspect of the present disclosure, the semiconductor light emitting element further includes a mask on the growth substrate, the mask has an opening, the nanowire layer is selectively grown from the opening provided in the mask, and the inclined side surface portion is formed in a region partially covering the mask.

According to an aspect of the present disclosure, the nanowire layer, the active layer, and the p-type layer are formed of a nitride semiconductor.

In order to solve the above problem, a method for producing a semiconductor light emitting element according to the present disclosure includes: a columnar semiconductor growth step of forming a plurality of columnar semiconductor layers on a growth substrate; and an embedded layer formation step of forming an embedded layer to cover the columnar semiconductor layer, in which the columnar semiconductor layer growth step includes a nanowire layer growth step of forming a nanowire layer having an inclined side surface portion which is a side surface inclined with respect to a main surface of the growth substrate, an active layer growth step of forming an active layer on an outer periphery of the inclined side surface portion, and a p-type layer growth step of forming a p-type layer on an outer periphery of the active layer.

According to an aspect of the present disclosure, the nanowire layer growth step includes a nanowire core growth step of forming a nanowire core having a side surface perpendicular to the main surface of the growth substrate, and an inclined side surface portion growth step of forming an inclined side surface portion on an outer periphery of the nanowire core.

According to an aspect of the present disclosure, in the inclined side surface portion growth step, a V/III ratio of a raw material is set to be lower than that in the nanowire core growth step.

According to an aspect of the present disclosure, in the inclined side surface portion growth step, a growth temperature is set to be lower than that in the nanowire core growth step.

### ADVANTAGEOUS EFFECTS OF INVENTION

The present disclosure can provide a semiconductor light emitting element and a method for producing a semiconductor light emitting element capable of increasing an amount of light extracted in a main surface direction and a back surface direction even in a case of a semiconductor light emitting element having a columnar semiconductor layer.

### BRIEF DESCRIPTION OF DRAWINGS

[FIG. 1A] FIG. 1A is a schematic cross-sectional view of a semiconductor light emitting element 10 according to a first embodiment.
[FIG. 1B] FIG. 1B is a partially enlarged cross-sectional view illustrating a columnar semiconductor layer of the semiconductor light emitting element 10 in an enlarged manner.
[FIG. 2] FIG. 2 is a graph illustrating a relation between the number of layers of a DBR and a reflectivity.
[FIG. 3A] FIG. 3A is a schematic view illustrating a mask formation step in a method for producing the semiconductor light emitting element 10.
[FIG. 3B] FIG. 3B is a schematic view illustrating a nanowire growth step in the method for producing the semiconductor light emitting element 10.
[FIG. 3C] FIG. 3C is a schematic view illustrating a growth step of an active layer 15 and a p-type layer 16 in the method for producing the semiconductor light emitting element 10.
[FIG. 3D] FIG. 3D is a schematic view illustrating a side surface reflection portion formation step in the method for producing the semiconductor light emitting element 10.
[FIG. 4E] FIG. 4E is a schematic view illustrating an embedded layer formation step in the method for producing the semiconductor light emitting element 10.
[FIG. 4F] FIG. 4F is a schematic view illustrating a mesa formation step in the method for producing the semiconductor light emitting element 10.
[FIG. 4G] FIG. 4G is a schematic view illustrating an electrode formation step in the method for producing the semiconductor light emitting element 10.
[FIG. 5] FIG. 5 is a schematic cross-sectional view illustrating the semiconductor light emitting element 10 according to a second embodiment.
[FIG. 6A] FIG. 6A is a schematic cross-sectional view illustrating a semiconductor light emitting element 30 according to a third embodiment.
[FIG. 6B] FIG. 6B is a partially enlarged cross-sectional view illustrating a columnar semiconductor layer of the semiconductor light emitting element 30 according to the third embodiment in an enlarged manner.
[FIG. 7A] FIG. 7A is a schematic view illustrating a mask formation step in a method for producing the semiconductor light emitting element 30 according to the third embodiment.
[FIG. 7B] FIG. 7B is a schematic view illustrating a nanowire growth step in the method for producing the semiconductor light emitting element 30.
[FIG. 7C] FIG. 7C is a schematic view illustrating a growth step of an active layer 35 and a p-type layer 36 in the method for producing the semiconductor light emitting element 30.
[FIG. 7D] FIG. 7D is a schematic view illustrating a side surface reflection portion formation step in the method for producing the semiconductor light emitting element 30.
[FIG. 8A] FIG. 8A is a schematic cross-sectional view illustrating a semiconductor light emitting element 110 according to a fourth embodiment.
[FIG. 8B] FIG. 8B is a partially enlarged cross-sectional view illustrating a columnar semiconductor layer of the semiconductor light emitting element 110 in an enlarged manner.
[FIG. 9A] FIG. 9A is a schematic view illustrating a mask formation step in a method for producing the semiconductor light emitting element 110.
[FIG. 9B] FIG. 9B is a schematic view illustrating a nanowire core growth step in a nanowire layer growth step in the method for producing the semiconductor light emitting element 110.
[FIG. 9C] FIG. 9C is a schematic view illustrating an inclined side surface portion growth step of the nanowire layer growth step in the method for producing the semiconductor light emitting element 110.
[FIG. 9D] FIG. 9D is a schematic view illustrating a growth step of an active layer 115 and a p-type layer 116 in the method for producing the semiconductor light emitting element 110.
[FIG. 10E] FIG. 10E is a schematic view illustrating an embedded layer formation step of the method for producing the semiconductor light emitting element 110.
[FIG. 10F] FIG. 10F is a schematic view illustrating a mesa formation step in the method for producing the semiconductor light emitting element 110.
[FIG. 10G] FIG. 10G is a schematic view illustrating an electrode formation step in the method for producing the semiconductor light emitting element 110.
[FIG. 11A] FIG. 11A is a schematic cross-sectional view illustrating a semiconductor light emitting element that has been proposed in the related art and that includes columnar semiconductor layers.
[FIG. 11B] FIG. 11B is a schematic perspective view illustrating light extraction directions of the semiconductor light emitting element that has been proposed in the related art and that includes columnar semiconductor layers.

### DESCRIPTION OF EMBODIMENTS

### (First Embodiment)

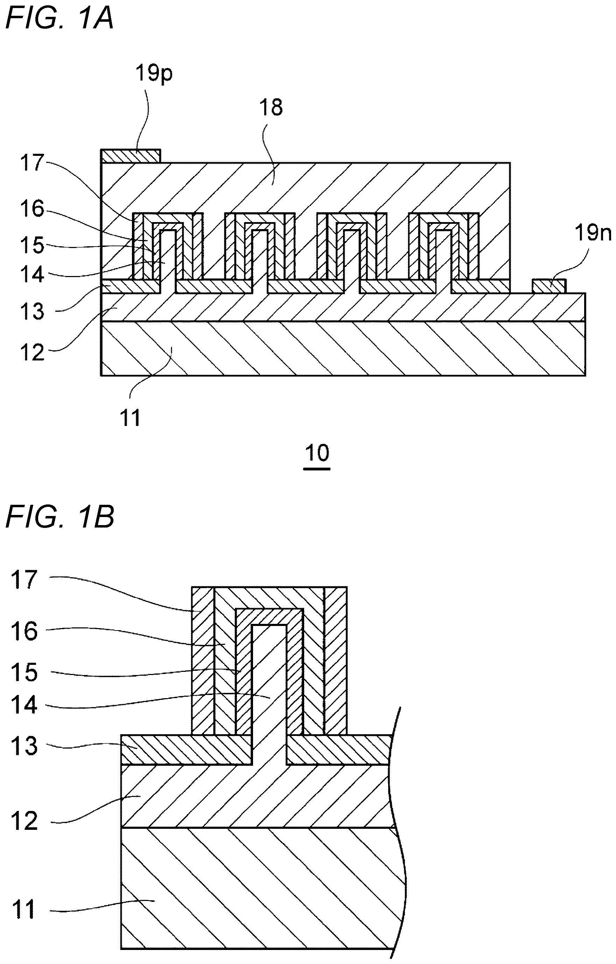

Hereinafter, embodiments of the present disclosure will be described in detail with reference to the drawings. The same or equivalent components, members, and processes illustrated in the drawings are denoted by the same reference numerals, and redundant description thereof will be omitted as appropriate. FIG. 1A is a schematic cross-sectional view illustrating a semiconductor light emitting element 10 according to the present embodiment, and FIG. 1B is a partially enlarged cross-sectional view illustrating a columnar semiconductor layer of the semiconductor light emitting element 10 in an enlarged manner.

As illustrated in FIG. 1A, the semiconductor light emitting element 10 includes a growth substrate 11, an underlying layer 12, masks 13, nanowire layers 14, active layers 15, p-type layers 16, side surface reflection portions 17, an embedded layer 18, a cathode electrode 19n, and an anode electrode 19p. Here, the nanowire layers 14, the active layers 15, and the p-type layers 16 are selectively grown in a direction perpendicular to the growth substrate 11 to form a columnar shape, and constitute columnar semiconductor layers disclosed herein. As illustrated in FIG. 1B, each columnar semiconductor layer has a side surface perpendicular to a main surface of the growth substrate 11, and the active layer 15 along the side surface constitutes a double hetero structure sandwiched between the nanowire layer 14 and the p-type layer 16.

As illustrated in FIG. 1A, the embedded layer 18 is removed from a part of a surface of the semiconductor light emitting element 10 to the underlying layer 12 to form a mesa groove (a mesa structure), and a surface of the underlying layer 12 is exposed and the cathode electrode 19n is formed. The anode electrode 19p is formed on the embedded layer 18. Here, the mesa structure refers to a structure in which a groove penetrating a plurality of semiconductor layers is formed to surround a predetermined region such that a cross section of a stacked structure of the semiconductor layers is exposed from a side surface.

The growth substrate 11 is a substantially flat plate-shaped member formed of a material supporting crystal growth of a semiconductor material. In a case where the semiconductor light emitting element 10 is formed of a nitride-based semiconductor, a GaN substrate is preferably used as the growth substrate 11, and for laser oscillation, a c-plane GaN substrate, on which a resonator plane is easy to be formed by cleavage, may be used. Alternatively, a different substrate such as a c-plane sapphire substrate or a Si substrate that is formed of a material different from the semiconductor material grown as the growth substrate 11 may be used.

The underlying layer 12 is a single crystal semiconductor layer formed on the growth substrate 11. When the growth substrate 11 and the underlying layer 12 are formed of different materials, it is preferable to grow a buffer layer on a surface of the growth substrate 11 and form the underlying layer 12 on the buffer layer. For example, the underlying layer 12 is constituted by a plurality of layers including an n-type semiconductor layer such as an n-type contact layer provided on undoped GaN having a thickness of several µm. The n-type contact layer is a semiconductor layer doped with n-type impurities, and examples thereof include Si-doped n-type Al_{0.05}Ga_{0.95}N. The mask 13 is formed on a main surface side of the underlying layer 12. A part of the underlying layer 12 is exposed and the cathode electrode 19n is formed.

The buffer layer is a layer formed between the growth substrate 11 and the underlying layer 12 to reduce lattice mismatch therebetween. When a c-plane sapphire substrate is used as the growth substrate 11, although GaN is preferably used for the buffer layer, AIN, AlGaN, and the like may also be used. When the growth substrate 11 and the underlying layer 12 are formed of the same material, the buffer layer may not be provided. When a single crystal substrate such as a GaN substrate is used as the growth substrate 11, the cathode electrode 19n may be formed on the surface of the growth substrate without providing the buffer layer and the underlying layer 12.

The mask 13 is a layer formed of a dielectric material formed on the surface of the underlying layer 12. As a material forming the mask 13, a material that is difficult to grow a crystal of a semiconductor from the mask 13 is selected, and examples thereof include SiO₂, SiNₓ, and Al₂O₃. The mask 13 is formed with a plurality of openings 13a to be described later, such that a semiconductor layer can be grown from a part of the surface of the underlying layer 12 exposed from the openings 13a.

The columnar semiconductor layer is a semiconductor layer crystal-grown in the openings 13a provided in the mask 13, and a substantially columnar semiconductor layer stands vertically with respect to the main surface of the growth substrate 11. Such a columnar semiconductor layer can be obtained by setting appropriate growth conditions according to a semiconductor material forming the columnar semiconductor layer and by performing selective growth in which a crystal plane in a specific orientation grows. In the example illustrated in FIGS. 1A and 1B, the plurality of openings 13a are two-dimensionally and periodically formed in the mask 13, and thus the columnar semiconductor layer is also two-dimensionally and periodically formed on the growth substrate 11.

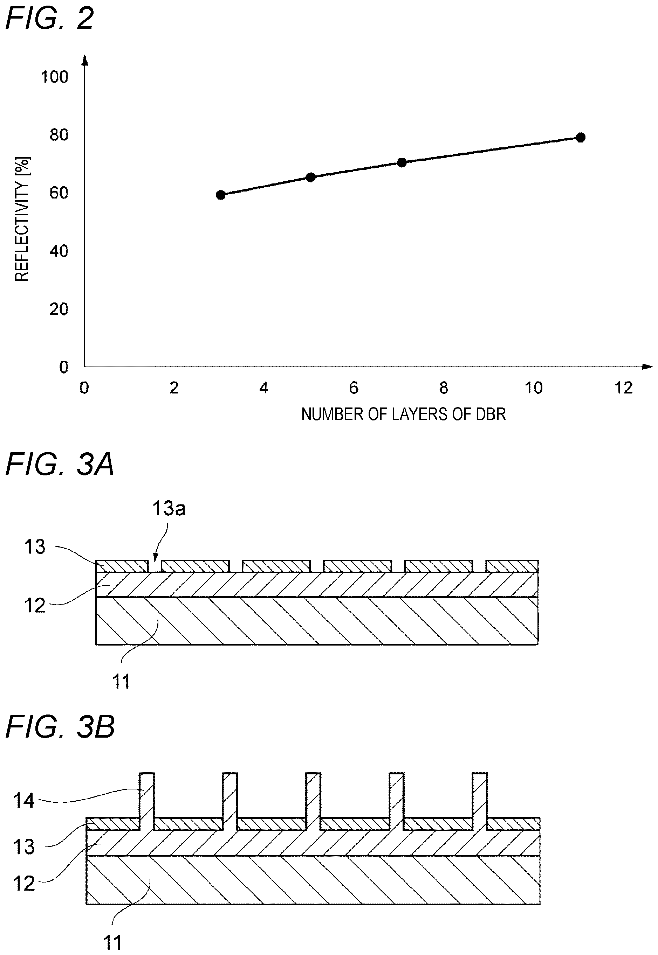

The nanowire layer 14 is a columnar semiconductor layer selectively grown on the underlying layer 12 exposed from the openings 13a (see FIG. 3A) of the mask 13, and is formed of, for example, GaN doped with n-type impurities. When GaN is used as the nanowire layer 14, the nanowire layer 14 selectively grown on the growth substrate 11 has a substantially hexagonal columnar shape in which six m-planes are formed as facets. In FIGS. 1A and 1B, it appears that the nanowire layer 14 is grown only in regions where the openings 13a are formed. However, in practice, the crystal growth also progresses on the mask 13 by lateral growth, and thus an enlarged hexagonal column is formed around the openings 13a. For example, when the openings 13a are each formed as a circle having a diameter of substantially 150 nm, it is possible to form the nanowire layer 14 having a hexagonal columnar shape and a height of substantially 1 µm to 2 µm with a hexagonal shape, as a bottom surface, inscribed in a circle having a diameter of substantially 240 nm. When the underlying layer 12 and the nanowire layer 14 are formed of GaN, the underlying layer 12 and the nanowire layer 14 are preferably n-type semiconductor layers having an electron concentration of about 10¹⁸ atoms/cm⁻³, for example.

Although GaN is used as the nanowire layer 14 in the present embodiment, GaInN may be used as the nanowire layer 14 in order to reduce misfit dislocations due to lattice mismatch, in a case where an In composition of the active layer 15 is increased in order to increase an emission wavelength. Similarly, when the wavelength of the semiconductor light emitting element 10 is to be shortened, AlGaN may be used as the nanowire layer 14, or a well layer and a barrier layer of the active layer 15 may be changed to AlGaN having different compositions.

The active layer 15 is a semiconductor layer grown on an outer periphery of the nanowire layer 14, and is, for example, a multiple quantum well active layer in which a GaInN quantum well layer having a thickness of 3 nm to 10 nm and a GaN barrier layer having a thickness of 5 nm to 20 nm are stacked five times. Here, the multiple quantum well active layer is exemplified, and a single quantum well structure or a bulk active layer may be used. The active layer 15 is formed on a side surface and an upper surface of the nanowire layer 14, and thus an area of the active layer 15 can be ensured. As a ratio of In adsorbed into the active layer increases, the emission wavelength of the semiconductor light emitting element 10 becomes longer, and the emission wavelength can be 480 nm or more, in a case where an In composition ratio is 0.10 or more. When the In composition ratio is 0.12 or more, the emission wavelength can be 500 nm or more. Since the side surface of the nanowire layer 14 is the m-plane, the active layer 15 formed on the side surface is also a nonpolar plane having the m-plane, such that droop characteristics can be improved.

The p-type layer 16 is a semiconductor layer grown on an outer periphery of the active layer 15, and is formed of, for example, GaN doped with p-type impurities. As illustrated in FIGS. 1A and 1B, the p-type layer 16 is formed to cover a side surface and an upper surface of the active layer 15. Accordingly, the nanowire layer 14, the active layer 15, and the p-type layer 16 form a double hetero structure, such that carriers are favorably confined in the active layer 15 and a probability of radiative recombination can be improved. Although FIGS. 1A and 1B illustrate an example in which the p-type layer 16 includes a single layer, the p-type layer 16 may have a multilayer structure of a plurality of layers covering the side surface of the active layer 15.

As illustrated in FIGS. 1A and 1B, the nanowire layer 14, the active layer 15, and the p-type layer 16 stand with respect to the main surface of the growth substrate 11, and constitute columnar semiconductor layers disclosed herein. The active layer 15 and the p-type layer 16 are formed along a side surface of the columnar semiconductor layer.

Each side surface reflection portion 17 is a film-like member (a light reflection film) that is formed in contact with an outer periphery of a side surface of the p-type layer 16 and reflects at least part of light emitted from the active layer 15. A material forming the side surface reflection portion 17 is not limited, and can use, for example, a metal material, a semiconductor material, or a dielectric material. As will be described in detail later, the side surface reflection portion 17 preferably has a reflectivity in a range of 30% to 90%, and more preferably in a range of 40% to 75%, with respect to the light emitted from the active layer 15.

When a metal material is used for the side surface reflection portion 17, a material that satisfactorily reflects a wavelength of the light emitted from the active layer 15 is preferably used, and, for example, a metal material containing any one of Al, Au, Ag, and Cr as a main component can be used. In addition, an alloy or a stacked structure of these materials may be used. When a metal material is used for the side surface reflection portion 17, a film thickness of the side surface reflection portion 17 is preferably in a range of 10 nm to 80 nm. By adjusting a thickness of a metal film within the above range, the above reflectivity with respect to the light emitted from the active layer 15 can be obtained.

When a semiconductor material is used for the side surface reflection portion 17, a semiconductor material having a band gap larger than the wavelength of the light emitted from the active layer 15 is preferably used in order to prevent absorption of the light emitted from the active layer 15. For example, a compound semiconductor material such as GaN, AlN, InN, AlGaN, InGaN, and AlInGaN may be used. When a semiconductor material is used for the side surface reflection portion 17, the film thickness of the side surface reflection portion 17 needs to be larger than the wavelength of the light emitted from the active layer 15. This is because, by making the optical film thickness larger than the wavelength of the light, reflection and refraction of the light due to a refractive index difference are utilized at an interface between the p-type layer 16 and the side surface reflection portion 17 and at an interface between the side surface reflection portion 17 and the embedded layer 18.

When a dielectric material is used for the side surface reflection portion 17, a distributed Bragg reflector (DBR) is preferably formed of a dielectric multilayer film in which a plurality of types of materials having different refractive indexes are alternately stacked. For example, a combination of dielectric materials such as HfO₂, TiO₂, Ta₂O₅, Al₂O₃, SiO₂, and MgF₂ may be used. When the side surface reflection portion 17 is formed of a dielectric multilayer film or a semiconductor multilayer film to form the DBR, the reflectivity can be controlled by forming each layer with a quarter wavelength and adjusting the number of stacked layers.

FIG. 2 is a graph illustrating a relation between the number of layers of the DBR and the reflectivity. The graph illustrated in FIG. 2 illustrates the relation between the number of layers of the DBR and the reflectivity in a multilayer film of GaN/Al_{0.27}Ga_{0.73}N with a wavelength of 440 nm. It can be seen that the reflectivity can be controlled in a range of 60% to 80% by adjusting the number of layers (the number of pairs of low refractive index layers and high refractive index layers). Although the reflectivity can be increased by further increasing the number of layers than that illustrated in FIG. 2, when the number of layers is too large, the number of steps for forming the side surface reflection portion 17 increases, and thus the number of layers is preferably in a range of 2 pairs to 12 pairs.

The embedded layer 18 is a layer that fills spaces between the plurality of side surface reflection portions 17 and upper surfaces of the columnar semiconductor layers. Examples of the material forming the embedded layer 18 include a semiconductor material such as GaN and a transparent electrode such as indium tin oxide (ITO). The anode electrode 19p is formed on a part of the surface of the embedded layer 18. Although FIGS. 1A and 1B illustrate an example in which the embedded layer 18 includes a single layer, a stacked structure of a plurality of layers may be used as long as the embedded layer 18 is embedded from the surface of the underlying layer 12 to an upper surface of the columnar semiconductor layer. When the embedded layer 18 is formed of a semiconductor material, a p-type semiconductor layer or an n-type semiconductor layer may be used to have functions of a tunnel junction layer, a contact layer, a current spreading layer, and the like.

The mesa groove is a groove penetrating each of the semiconductor layers from the embedded layer 18 up to the underlying layer 12, and divides a light emitting region of the semiconductor light emitting element 10 to form a mesa structure. The mesa groove is further formed with an element isolation groove to separate the semiconductor light emitting elements 10 individually.

The cathode electrode 19n is an electrode formed in a region where the underlying layer 12 is exposed in the mesa groove, and is constituted by a stacked structure of a metal material and a pad electrode, which is in ohmic contact with the exposed semiconductor layer. The anode electrode 19p is an electrode formed on a part of the embedded layer 18, and is constituted by a stacked structure of a metal material and a pad electrode, which is in ohmic contact with the outermost surface of the embedded layer 18. Although not illustrated in FIGS. 1A and 1B, a known structure such as covering the surface of the semiconductor light emitting element 10 with a passivation film may be applied as necessary. Alternatively, a transparent electrode obtained by extending the anode electrode 19p on the entire embedded layer 18 may be provided.

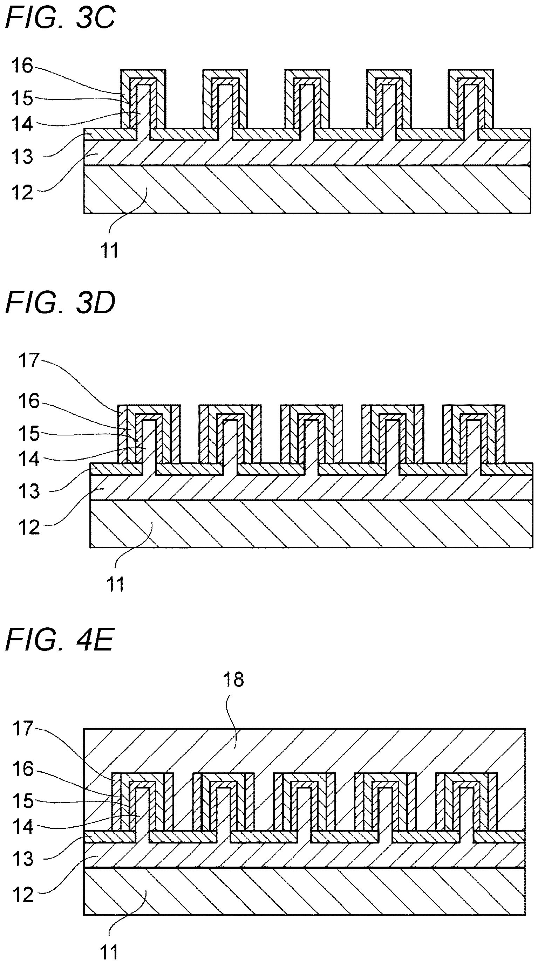

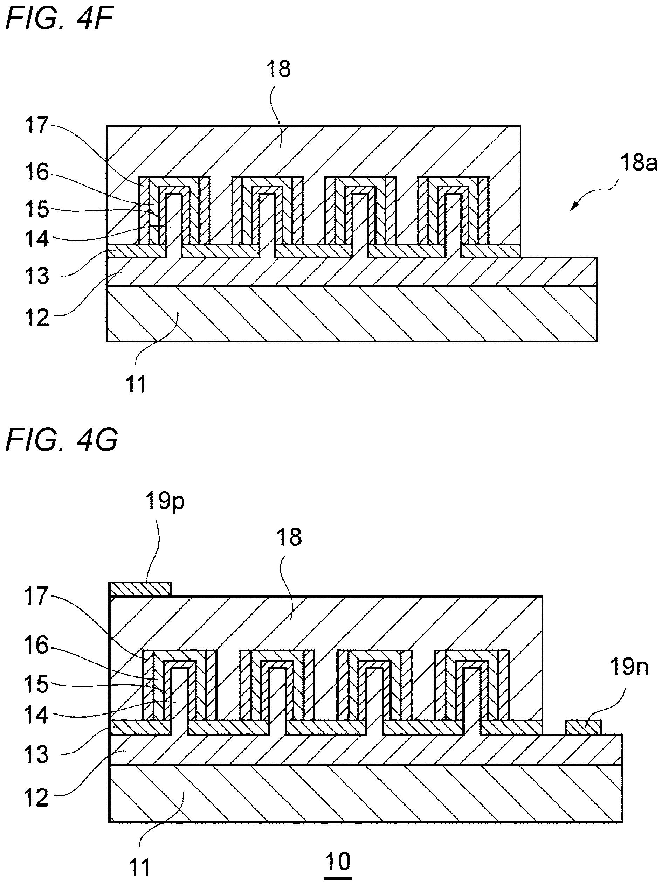

FIGS. 3A to 3D are schematic views illustrating a method for producing the semiconductor light emitting element 10, in which FIG. 3A illustrates a mask formation step, FIG. 3B illustrates a nanowire growth step, FIG. 3C illustrates a growth step of the active layer 15 and the p-type layer 16, and FIG. 3D illustrates a side surface reflection portion formation step. FIGS. 4E to 4G are schematic views illustrating the method for producing the semiconductor light emitting element 10, in which FIG. 4E illustrates an embedded layer formation step, FIG. 4F illustrates a mesa formation step, and FIG. 4G illustrates an electrode formation step.

First, as illustrated in FIG. 3A, the growth substrate 11 on which the underlying layer 12 formed of n-type GaN is formed is prepared. In the mask formation step, the masks 13 formed of SiO₂ are deposited on the underlying layer 12 by a sputtering method to a thickness of about 30 nm to form the openings 13a having a diameter of about 150 nm. A fine pattern forming method such as nanoimprint lithography may be used to form the openings 13a. When a different substrate such as sapphire is used as the growth substrate 11, a buffer layer, the underlying layer 12, and an n-type semiconductor layer may be formed on the sapphire substrate, and a surface of the n-type semiconductor layer may be used as the surface of the growth substrate 11. Growth conditions of the buffer layer are, for example: trimethylalminium (TMA), trimethylgallium (TMG), and ammonia are used as source gases; a growth temperature is 1100°C; a V/III ratio is 1000; and a pressure is 10 hPa using hydrogen as a carrier gas. Growth conditions of the underlying layer and the n-type semiconductor layer are, for example: a growth temperature is 1050°C; a V/III ratio is 1000; and a pressure is 500 hPa using hydrogen as a carrier gas.

Next, in the nanowire growth step illustrated in FIG. 3B, the nanowire layer 14 formed of GaN is grown on the underlying layer 12 exposed from the openings 13a by selective growth by MOCVD. Growth conditions of the nanowire layer 14 are, for example: TMG and ammonia are used as source gases; a growth temperature is 1050°C; a V/III ratio is 10; and a pressure is 100 hPa using hydrogen as a carrier gas.

Next, in the growth step of the active layer 15 and the p-type layer 16 illustrated in FIG. 3C, the active layer 15 and the p-type layer 16 are grown on the side surface and the upper surface of the nanowire layer 14 by MOCVD. The active layer 15 has, for example, a multiple quantum well structure in which a GaInN quantum well layer having a thickness of 5 nm and a GaN barrier layer having a thickness of 10 nm are stacked five times. The nanowire growth step illustrated in FIG. 3B and the growth step of the active layer 15 and the p-type layer 16 illustrated in FIG. 3C corresponds to the columnar semiconductor layer growth step disclosed herein.

Growth conditions of the active layer 15 are, for example: a growth temperature is 800°C; a V/III ratio is 3000; nitrogen is used as a carrier gas; the pressure is 1000 hPa; and TMG, trimethylindium (TMI), and ammonia are used as source gases. The p-type layer 16 is, for example, p-type GaN doped with p-type impurities. Growth conditions of the p-type layer 16 are, for example: a growth temperature is 950°C; a V/III ratio is 4000; a pressure is 300 hPa using hydrogen as a carrier gas; and TMG, bis(cycropentadienyl)magnesium (Cp₂Mg), and ammonia are used as source gases.

Next, in the side surface reflection portion formation step illustrated in FIG. 3D, the side surface reflection portion 17 is formed along the side surface of the p-type layer 16. When the side surface reflection portion 17 is formed of a semiconductor material, the side surface reflection portion 17 can be grown on the side surface of the p-type layer 16 in the same reaction chamber following the growth of the p-type layer 16. When a metal material or a dielectric material is used for the side surface reflection portion 17, the side surface reflection portion 17 can be formed on the side surface of the p-type layer 16 by a sputtering method or a vapor deposition method after the growth of the p-type layer 16. At this time, by disposing the growth substrate 11 to be inclined with respect to a supply direction of a film material, a film formed of a metal material or a dielectric material can be formed on the side surface of the p-type layer 16 with an appropriate film thickness. By forming the gradient of the growth substrate 11 in a plurality of directions, a film formed of a metal material or a dielectric material can be formed on the entire side surface of the p-type layer 16. A metal material and a dielectric material attached to the top of the columnar semiconductor layer are preferably removed by dry etching or the like.

Next, in the embedded layer formation step illustrated in FIG. 4E, the embedded layer 18 is formed to cover spaces between the side surface reflection portions 17 formed in the plurality of columnar semiconductor layers and the upper surfaces of the p-type layers 16. In a case where the embedded layer 18 is formed of a p-type semiconductor layer, growth conditions of the embedded layer 18 is, for example: a growth temperature is 950°C; a V/III ratio is 1000; a pressure is 300 hPa using hydrogen as a carrier gas; and TMG, Cp₂Mg, and ammonia can be used as source gases. When the embedded layer 18 is formed of a transparent electrode such as ITO, a known method such as a sputtering method can be used.

As described above, the embedded layer 18 needs to grow on the mask 13 provided between columnar semiconductor layers, and a gap may be generated at a lower portion of the columnar semiconductor layers when the embedded layer 18 is grown. Accordingly, in the growth of the embedded layer 18, the embedded layer 18 preferably grows using TMG, silane, and ammonia as source gases at a low temperature and a low V/III ratio in which m-plane growth, which is lateral growth, is promoted in an initial stage. Examples of the low temperature and low V/III ratio include a V/III ratio of 100 or less at 800°C or less and a pressure of 200 hPa using hydrogen as a carrier gas. After the mask 13 is filled without gaps at the lower portion of the columnar semiconductor layers by the lateral growth of the embedded layer 18, the growth is preferably performed at a high temperature and a high V/III ratio that promotes the c-plane growth, which is vertical growth. Examples of the high temperature and high V/III ratio include a V/III ratio of 2000 or more at 1000°C or more, and a pressure of 500 hPa using hydrogen as a carrier gas.

Next, in a mesa formation step illustrated in FIG. 4F, the embedded layer 18 to the underlying layer 12 are partially removed by selective dry etching to expose the upper surface of the underlying layer 12 and form the mesa groove. The mesa groove is formed to define a region surrounded by the mesa groove as a light emitting region of the semiconductor light emitting element 10.

Next, in an electrode formation step illustrated in FIG. 4G, the cathode electrode 19n is formed on the surface of the underlying layer 12 exposed in the mesa groove, and the anode electrode 19p is formed on the embedded layer 18. When necessary, annealing, forming of a passivation film, and element division are performed after the formation of the electrodes to obtain the semiconductor light emitting element 10.

In the semiconductor light emitting element 10 according to the present embodiment, in a case where a voltage is applied between the cathode electrode 19n and the anode electrode 19p, a current flows through the embedded layer 18, the p-type layer 16, the active layer 15, the nanowire layer 14, and the underlying layer 12 in this order, and light is generated in the active layer 15 due to radiative recombination. The light emitted from the active layer 15 reaches the side surface reflection portion 17 and is partially reflected, but since the reflected light travels in a vertical direction according to an incident angle, the light is extracted in the main surface direction of the semiconductor light emitting element 10 by repeating the reflection a plurality of times.

As described above, the side surface reflection portion 17 preferably has a reflectivity in a range of 30% to 90%, and more preferably in a range of 40% to 75%, with respect to the light emitted from the active layer 15. If the reflectivity is too high, a rate at which the light emitted from the active layer 15 is repeatedly reflected and absorbed inside the columnar semiconductor layer increases, and it becomes difficult to improve an amount of light extracted to an outside. If the reflectivity is too low, an amount of light extracted from a lateral direction of the semiconductor light emitting element 10 increases, and it becomes difficult to improve light extraction efficiency in the main surface direction.

In one columnar semiconductor layer, a part of the light emitted from the active layer 15 is reflected by the side surface reflection portion 17 formed on the side surface of the columnar semiconductor layer and travels upward, and the remaining part of the light is transmitted through the side surface reflection portion 17. The light transmitted through the side surface reflection portion 17 propagates in the embedded layer 18 and reaches another side surface reflection portion 17 provided in another columnar semiconductor layer, and part of the light is reflected and travels upwards. Accordingly, by setting the reflectivity of the side surface reflection portion 17 within the above range, the light emitted from one active layer 15 is reflected upward by the plurality of side surface reflection portions 17, and an amount of light extracted in the main surface direction in the entire semiconductor light emitting element 10 can be increased.

Since the side surface of the nanowire layer 14 is an m-plane formed by selective growth, the active layer 15 and the p-type layer 16 formed on the outer periphery of the nanowire layer 14 are in contact with each other on the m-plane. Since the m-plane is a nonpolar plane and is not polarized, the active layer 15 has high luminous efficiency. Since all side surfaces of a hexagonal column are m-planes, luminous efficiency of the semiconductor light emitting element 10 can be improved. Further, since the film thickness of the active layer can be increased, the volume of the active layer 15 can be increased to substantially 3 times to 10 times as large as that of a semiconductor light emitting element in the related art, and an injected carrier density can be reduced to significantly reduce an efficiency droop.

As described above, in the semiconductor light emitting element and the method for producing a semiconductor light emitting element according to the present embodiment, the side surface reflection portion 17 is formed in contact with the side surface of the columnar semiconductor layer including the nanowire layer 14, the active layer 15, and the p-type layer 16. Therefore, part of the light emitted from the active layer 15 is reflected, and the amount of light extracted in the main surface direction can be increased.

By setting the reflectivity of the side surface reflection portion 17 with respect to the light emitted from the active layer 15 within a range of 30% to 90%, the light emitted from one active layer 15 is reflected by the plurality of side surface reflection portions 17, and the amount of light extracted in the main surface direction of the entire semiconductor light emitting element 10 can be increased.

### (Second Embodiment)

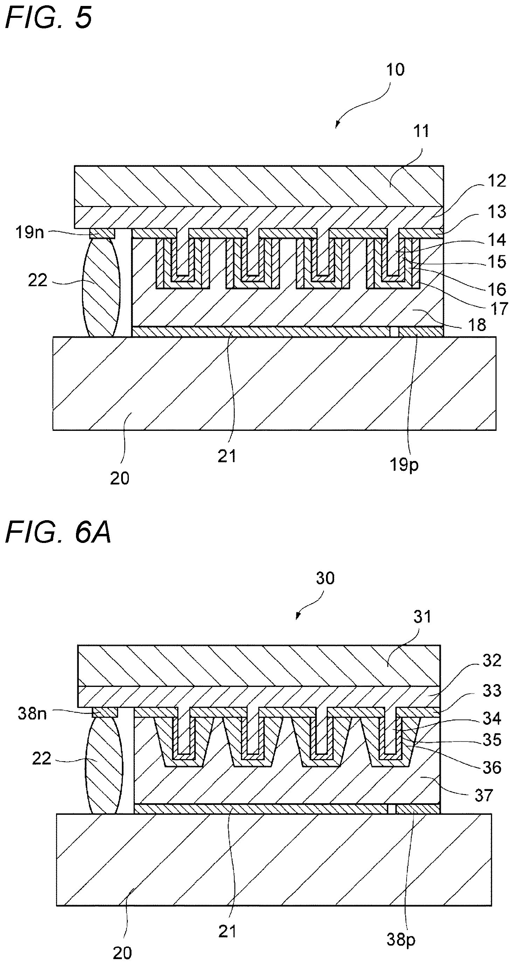

Next, a second embodiment of the present disclosure will be described with reference to FIG. 5. Description of contents overlapping with the first embodiment will be omitted. FIG. 5 is a schematic cross-sectional view illustrating the semiconductor light emitting element 10 according to the present embodiment. The present embodiment is different from the first embodiment in that the semiconductor light emitting element 10 is flip-chip mounted. As illustrated in FIG. 5, the semiconductor light emitting element 10 includes the growth substrate 11, the underlying layer 12, the masks 13, the nanowire layers 14, the active layers 15, the p-type layers 16, the side surface reflection portions 17, the embedded layer 18, the cathode electrode 19n, the anode electrode 19p, a mounting portion 20, an upper surface reflection portion 21, and a solder 22.

The mounting portion 20 is a member for mounting the semiconductor light emitting element 10 by flip-chip connection, and a wiring pattern or a land for supplying a current to the semiconductor light emitting element 10 is formed on an upper surface of the mounting portion 20. A specific configuration of the mounting portion 20 is not limited, and a known submount, a printed wiring board, or the like can be used. A material forming the mounting portion 20 is not limited, and can use ceramic, an insulator, a glass epoxy resin, a composite substrate of a metal and an insulating film, or the like.

The upper surface reflection portion 21 is provided on a surface of the embedded layer 18 opposite to the growth substrate 11. The upper surface reflection portion 21 is a film-like member that reflects the light emitted from the active layer 15 toward the growth substrate 11. The upper surface reflection portion 21 may be formed on the embedded layer 18 of the semiconductor light emitting element 10 or may be formed on the surface of the mounting portion 20 as long as the upper surface reflection portion 21 is formed between the embedded layer 18 and the mounting portion 20. A material forming the upper surface reflection portion 21 is not limited, and can use, for example, a metal material such as Al, Au, Ag, or Cr.

The solder 22 is a member for electrically connecting the cathode electrode 19n to a wiring pattern on the mounting portion 20. Although not illustrated in FIG. 5, a solder is also provided between the anode electrode 19p and the mounting portion 20, and the anode electrode 19p and a wiring pattern on the mounting portion 20 are electrically connected to the solder (not illustrated).

In the present embodiment, part of the light emitted from the active layer 15 is reflected by the side surface reflection portion 17 and extracted from a back surface of the growth substrate 11. In addition, part of the light is reflected by the side surface reflection portion 17, travels toward the mounting portion 20, and reaches the upper surface reflection portion 21. The light that reaches the upper surface reflection portion 21 is totally reflected by the upper surface reflection portion 21 and extracted to an outside from the back surface of the growth substrate 11. In addition, since the light transmitted through the side surface reflection portion 17 propagates in the embedded layer 18, reaches another side surface reflection portion 17 provided in another columnar semiconductor layer, and is reflected, the light is similarly extracted from the back surface of the growth substrate 11.

As described above, in the semiconductor light emitting element 10 according to the present embodiment, the side surface reflection portion 17 is formed in contact with the side surface of the columnar semiconductor layer including the nanowire layer 14, the active layer 15, and the p-type layer 16, and the upper surface reflection portion 21 is formed in the embedded layer 18. Therefore, an amount of light extracted from the back surface of the growth substrate 11 can be increased.

### (Third Embodiment)

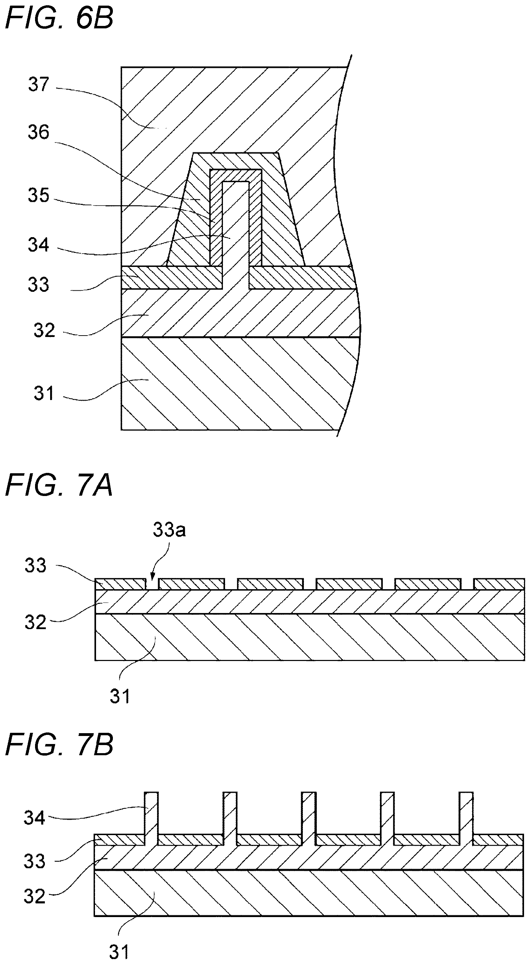

Next, a third embodiment of the present disclosure will be described with reference to FIGS. 6A to 7D. Description of contents overlapping with the first embodiment will be omitted. FIGS. 6A and 6B are diagrams illustrating a semiconductor light emitting element 30 according to the present embodiment, FIG. 6A is a schematic cross-sectional view, and FIG. 6B is a partially enlarged cross-sectional view illustrating a columnar semiconductor layer in an enlarged manner.

As illustrated in FIG. 6A, the semiconductor light emitting element 30 of the present embodiment includes a growth substrate 31, an underlying layer 32, masks 33, nanowire layers 34, active layers 35, p-type layers 36, an embedded layer 37, a cathode electrode 38n, an anode electrode 38p, the mounting portion 20, the upper surface reflection portion 21, and the solder 22. As illustrated in FIG. 6B, a side surface of the p-type layer 36 has an inclined side surface inclined with respect to a main surface of the growth substrate 31.

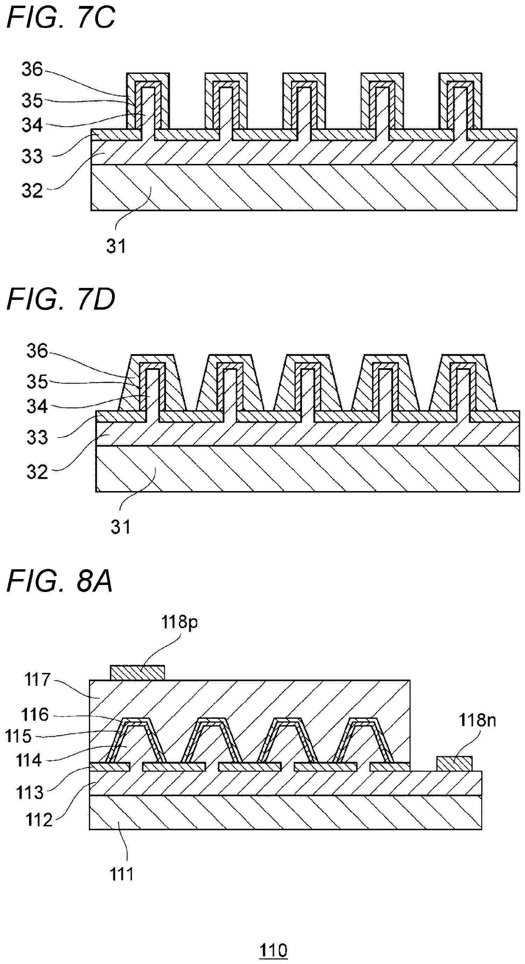

First, as illustrated in FIG. 7A, the growth substrate 31 on which the underlying layer 32 is formed is prepared, and the mask 33 having an opening 33a is formed in a mask formation step. Next, as illustrated in FIG. 7B, the nanowire layer 34 is formed in a nanowire growth step. Next, as illustrated in FIG. 7C, the active layer 35 and the p-type layer 36 are formed. Here, specific examples of the mask formation step, a nanowire growth step, and a step of forming the active layer 35 and the p-type layer 36 are the same as those of the first embodiment.

Next, as illustrated in FIG. 7D, a side surface reflection portion formation step is performed by continuing the growth of the p-type layer 36 under a growth condition in which the side surface of the p-type layer 36 becomes an inclined side surface inclined with respect to the main surface of the growth substrate 31. At this time, examples of a condition under which the side surface of the p-type layer 36 becomes the inclined side surface include a condition under which the growth temperature is lowered or the V/III ratio is lowered as compared with a growth condition under which an m-plane is grown as a facet. For example, when the growth conditions of the p-type layer 36 on the vertical m-plane in FIG. 7C are that a growth temperature is 950°C and a V/III ratio is 4000, the growth conditions include: a growth temperature is set to 950°C and a V/III ratio is set to 2000; a growth temperature is set to 900°C and a V/III ratio is set to 4000; and a growth temperature is set to 900°C and a V/III ratio is set to 3000.

Here, as illustrated in FIGS. 7C and 7D, an example in which the growth condition of the p-type layer 36 is changed in two stages is illustrated, but a side surface of the m-plane is not finally formed in the p-type layer 36. After the formation of the active layer 35, the p-type layer 36 may be grown with the side surface of the p-type layer 36 as the inclined side surface under one-step growth conditions using growth conditions under which the inclined side surface is formed.

After the side surface reflection portion formation step illustrated in FIG. 7D, the embedded layer 37 is formed in the embedded layer formation step as in FIG. 4E. Thereafter, the upper surface reflection portion 21 is formed on the embedded layer 37, a mesa groove is formed in a mesa formation step as in FIG. 4F, and the cathode electrode 19n and the anode electrode 19p are formed in the electrode formation step as in FIG. 4G. When necessary, annealing, forming of a passivation film, and element division are performed after the formation of the electrodes to obtain the semiconductor light emitting element 30.

In the present embodiment, an interface between the inclined side surface of the p-type layer 36 and the embedded layer 37 constitutes a side surface reflection portion, and the side surface reflection portion has a pointed tower shape in which a diameter decreases in a direction away from the growth substrate 31. The embedded layer 37 is formed of a material having a refractive index different from that of the p-type layer 36 of the columnar semiconductor layer. Accordingly, part of the light emitted from the active layer 35 is reflected by a refractive index difference at the interface (the side surface reflection portion) between the p-type layer 36 and the embedded layer 37, and is extracted to an outside from a back surface of the growth substrate 31. Part of the light travels toward the mounting portion 20 and reaches the upper surface reflection portion 21. The light that reaches the upper surface reflection portion 21 is totally reflected by the upper surface reflection portion 21 and extracted to an outside from the back surface of the growth substrate 31.

Further, the light transmitted from the p-type layer 36 to the embedded layer 37 propagates in the embedded layer 37, reaches an interface between another p-type layer 36 provided in another columnar semiconductor layer and the embedded layer 37, is reflected or refracted, and is similarly extracted from the back surface of the growth substrate 31.

FIGS. 7A to 7D are schematic views illustrating a method for producing the semiconductor light emitting element 30 according to the present embodiment, in which FIG. 7A illustrates a mask formation step, FIG. 7B illustrates a nanowire growth step, FIG. 7C illustrates a growth step of the active layer 35 and the p-type layer 36, and FIG. 7D illustrates a side surface reflection portion formation step. The present embodiment is different from the first embodiment in that the side surface of the p-type layer 36 is formed to be inclined instead of the side surface reflection portion formation step illustrated in FIG. 3D.

As described above, in the semiconductor light emitting element 30 according to the present embodiment, the p-type layer 36 and the embedded layer 37 are formed of materials having different refractive indices, and the side surface of the p-type layer 36 has an inclined side surface inclined with respect to the main surface of the growth substrate 31. Accordingly, a side surface reflection portion is formed at the interface between the p-type layer 36 and the embedded layer 37, and light emitted from the active layer 35 is extracted from the back surface of the growth substrate 31 by reflection and refraction due to a refractive index difference. Accordingly, an amount of light extracted from the back surface of the growth substrate 31 may be increased.

### (Fourth Embodiment)

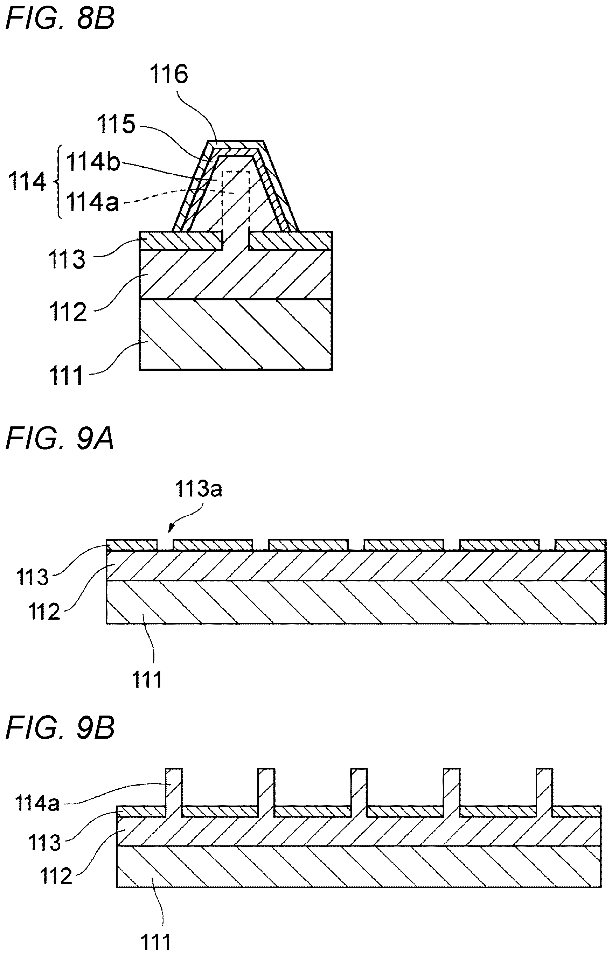

FIGS. 8A and 8B are diagrams illustrating a semiconductor light emitting element 110 according to a fourth embodiment, FIG. 8A is a schematic cross-sectional view, and FIG. 8B is a partially enlarged cross-sectional view illustrating a columnar semiconductor layer in an enlarged manner.

As illustrated in FIG. 8A, the semiconductor light emitting element 110 includes a growth substrate 111, an underlying layer 112, masks 113, nanowire layers 114, active layers 115, p-type layers 116, an embedded layer 117, a cathode electrode 118n, and an anode electrode 118p. Here, the nanowire layers 114, the active layers 115, and the p-type layers 116 are selectively grown on the growth substrate 111 to have a columnar shape standing in a vertical direction, and constitute columnar semiconductor layers disclosed herein. As illustrated in FIG. 8B, each columnar semiconductor layer has side surfaces (inclined side surface portions) inclined with respect to a main surface of the growth substrate 111, and has a trapezoidal cross section. Here, a case where the columnar semiconductor layer has a top surface and the cross section is trapezoidal is illustrated, but most of the surfaces may be constituted by inclined side surfaces with the top surface reduced, and the cross section may be triangular. The active layer 115 along the side surface of the nanowire layer 114 forms a double hetero structure sandwiched between the nanowire layer 114 and the p-type layer 116.

As illustrated in FIG. 8A, the embedded layer 117 is removed from a part of a surface of the semiconductor light emitting element 110 to the underlying layer 112 to form a mesa groove (a mesa structure), and a surface of the underlying layer 112 is exposed and the cathode electrode 118n is formed. The anode electrode 118p is formed on the embedded layer 117. Here, the mesa structure refers to a structure in which a groove penetrating a plurality of semiconductor layers is formed to surround a predetermined region such that a cross section of a stacked structure of the semiconductor layers is exposed from a side surface.

The growth substrate 111 is similar to the growth substrate 11 according to the first embodiment.

The underlying layer 112 is similar to the underlying layer 12 according to the first embodiment.

The buffer layer is a layer formed between the growth substrate 111 and the underlying layer 112 to reduce lattice mismatch therebetween. When a c-plane sapphire substrate is used as the growth substrate 111, although GaN is preferably used for the buffer layer, AlN, AlGaN, and the like may also be used. When the growth substrate 111 and the underlying layer 112 are formed of the same material, the buffer layer may not be provided. When a single crystal substrate such as a GaN substrate is used as the growth substrate 111, the cathode electrode 118n may be formed on the surface of the growth substrate without providing the buffer layer and the underlying layer 112.

The mask 113 is similar to the mask 13 according to the first embodiment.

The columnar semiconductor layer is a semiconductor layer crystal-grown in openings 113a provided in the masks 113, and has a columnar structure in which a semiconductor layer is formed to stand in a vertical direction with respect to the main surface of the growth substrate 111. Such a columnar semiconductor layer can be obtained by setting appropriate growth conditions according to a semiconductor material forming the columnar semiconductor layer and by performing selective growth in which a crystal plane in a specific orientation grows. In the example illustrated in FIG. 8A, a plurality of openings 113a are two-dimensionally and periodically formed in the mask 113, and thus the columnar semiconductor layer is also two-dimensionally and periodically formed on the growth substrate 111.

The nanowire layer 114 is a columnar semiconductor layer selectively grown on the underlying layer 112 exposed from the openings 113a of the mask 113, and is formed of, for example, GaN doped with n-type impurities. As illustrated in FIG. 8B, the nanowire layer 114 includes the nanowire core 114a and the inclined side surface portion 114b. The nanowire core 114a is a region indicated by broken lines in FIG. 8B, and is a columnar layer formed in a region extending vertically from the opening 113a of the mask 113. The inclined side surface portion 114b is a layer formed around the nanowire core 114a, and is formed to partially cover the mask 113. In addition, a side surface of the inclined side surface portion 114b constitutes a side surface of the nanowire layer 114, the nanowire layer 114 has a large diameter at a side close to the growth substrate 111 and has a small diameter toward a vicinity of a tip of the nanowire core 114a, the inclined side surface portion 114b is inclined with respect to the main surface of the growth substrate 111, and the cross section has a trapezoidal shape. In FIG. 8B, the nanowire core 114a is indicated by broken lines, and is described separately from the inclined side surface portion 114b formed around the nanowire core 114a. However, both can be formed of the same material, in this case, no clear boundary is formed.

When GaN is used for the nanowire layer 114, the nanowire core 114a selectively grown on the growth substrate 111 has a substantially hexagonal columnar shape in which six m-planes are formed as facets. In FIG. 8B, it appears that the nanowire core 114a is grown only in regions where the openings 113a are formed. However, in practice, the crystal growth also progresses on the mask 113 by lateral growth, and thus an enlarged hexagonal column is formed around the openings 113a. For example, when the openings 113a are each formed as a circle having a diameter of substantially 150 nm, it is possible to form the nanowire core 114a having a hexagonal columnar shape and a height of substantially 1 to 2 µm with a hexagonal shape, as a bottom surface, inscribed in a circle having a diameter of substantially 200 nm. When the underlying layer 112 and the nanowire layer 114 are formed of GaN, the underlying layer 112 and the nanowire layer 114 are preferably n-type semiconductor layers having an electron concentration of about 10¹⁸ atoms/cm⁻³, for example.

Although GaN is used as the nanowire layer 114 in the present embodiment, GaInN may be used as the nanowire layer 114 in order to reduce misfit dislocations due to lattice mismatch, in a case where an In composition of the active layer 115 is increased in order to increase an emission wavelength. Similarly, in a case where the wavelength of the semiconductor light emitting element 110 is to be shortened, AlGaN may be used as the nanowire layer 114, or a well layer and a barrier layer of the active layer 115 may be changed to AlGaN having different compositions.

A composition of the active layer 115 is the same as that of the active layer 15 according to the first embodiment.

Since the active layer 115 is formed on an outer periphery of the nanowire layer 114, the active layer 115 has a semipolar plane inclined with respect to the main surface of the growth substrate 111 similarly to the side surface of the nanowire layer 114. Here, the semipolar plane in GaN is a plane whose inclination from the c-plane is larger than 0 degrees and smaller than 90 degrees. Accordingly, since a voltage is applied to the semipolar plane inclined from the c-plane of GaN in the active layer 115, droop characteristics can be improved. In addition, the light emitted from the active layer 115 contains a large number of components in a direction perpendicular to the inclined side surface portion 114b, and the proportion of light traveling obliquely upward of the growth substrate 111 increases.

The p-type layer 116 is a semiconductor layer grown on an outer periphery of the active layer 115, and is formed of, for example, GaN doped with p-type impurities. As illustrated in FIG. 8A, the p-type layer 116 is formed to cover a side surface and an upper surface of the active layer 115. Accordingly, the nanowire layer 114, the active layer 115, and the p-type layer 116 form a double hetero structure, such that carriers are favorably confined in the active layer 115 and a probability of radiative recombination can be improved. Although FIG. 8A illustrates an example in which the p-type layer 116 is formed of a single layer, the p-type layer 116 may have a multilayer structure of a plurality of layers covering the side surface of the active layer 115. Since the p-type layer 116 is formed on an outer periphery of the active layer 115, the p-type layer 116 is inclined with respect to the main surface of the growth substrate 111 similarly to the side surfaces of the nanowire layer 114 and the active layer 115.

The configuration, composition, and function of the embedded layer 117 are similar to those of the embedded layer 18 according to the first embodiment.

The mesa groove is similar to the mesa groove according to the first embodiment.

The cathode electrode 118n is similar to the cathode electrode 19n according to the first embodiment.

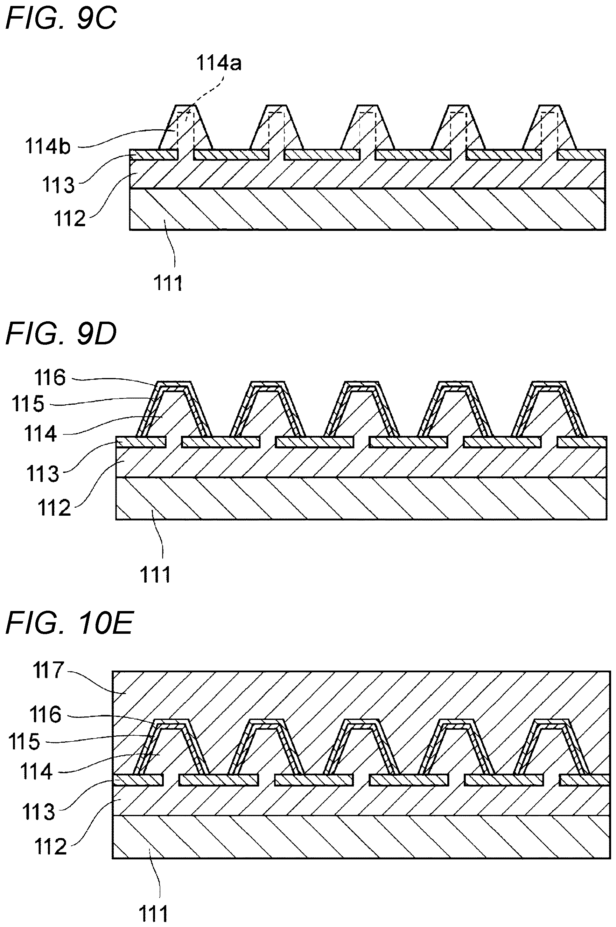

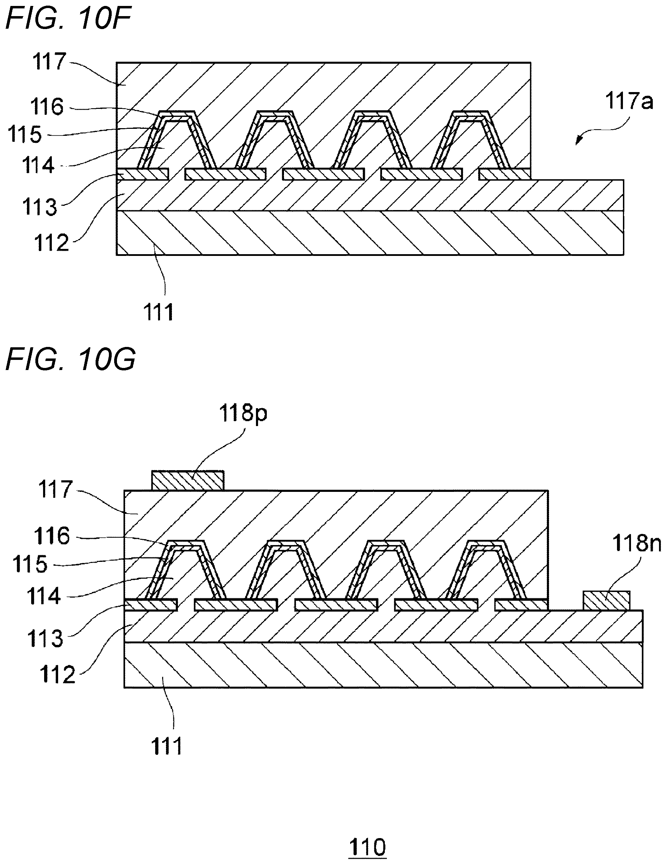

FIGS. 9A to 9D are schematic views illustrating a method for producing the semiconductor light emitting element 110, in which FIG. 9A illustrates a mask formation step, FIG. 9B illustrates a nanowire core growth step of a nanowire layer growth step, FIG. 9C illustrates an inclined side surface portion growth step of the nanowire layer growth step, and FIG. 9D illustrates a growth step of the active layer 115 and the p-type layer 116. The nanowire core growth step and the inclined side surface portion growth step form the nanowire layer 114 including an inclined side surface portion 114b under two-step growth conditions, and correspond to the nanowire layer growth step disclosed herein. FIGS. 10E to 10G are schematic views illustrating the method for producing the semiconductor light emitting element 110, in which FIG. 10E illustrates an embedded layer formation step, FIG. 10F illustrates a mesa formation step, and FIG. 10G illustrates an electrode formation step.

First, as illustrated in FIG. 9A, the growth substrate 111 on which the underlying layer 112 formed of n-type GaN is formed is prepared. The mask formation step is the same as that in the first embodiment.

Next, in the nanowire core growth step illustrated in FIG. 9B, the nanowire core 114a formed of GaN is grown on the underlying layer 112 exposed from the openings 113a by selective growth by MOCVD. Growth conditions of the nanowire core 114a are, for example: TMG and ammonia are used as source gases; a growth temperature is 1100°C; a V/III ratio is 20; and a pressure is 100 hPa using hydrogen as a carrier gas. Under these growth conditions, the nanowire core 114a is grown in a hexagonal column shape with an m-plane perpendicular to the growth substrate 111 as a facet.

Next, in the inclined side surface portion growth step illustrated in FIG. 9C, the crystal growth is continued on a side surface and an upper surface of the nanowire core 114a to grow the inclined side surface portion 114b having the side surface inclined with respect to the main surface of the growth substrate 111. Growth conditions of the inclined side surface portion 114b include a condition in which a V/III ratio of a raw material is lower or a growth temperature is lower compared with the growth conditions of the nanowire cores 114a. For example, the V/III ratio is in a range of 1000 to 5000, and the growth temperature is in a range of 900°C to 950°C.

By performing the inclined side surface portion growth step under the growth conditions described above, the inclined side surface portion 114b formed around the nanowire core 114a has a side surface with the semipolar planes as facets and has a trapezoidal cross section. Since the nanowire core 114a has a hexagonal column shape, the nanowire layer 114 including the nanowire core 114a and the inclined side surface portion 114b is formed in a hexagonal pyramid shape. Here, examples of the facets of the semipolar planes include those having high-order plane indexes represented by [10-11] [10-12] [10-13] [20-21] [30-31], and inclination angles with respect to the c-plane are 62 degrees, 43 degrees, 32 degrees, 75 degrees, and 80 degrees.

Next, in the growth steps of the active layer 115 and the p-type layer 116 illustrated in FIG. 9D, the active layer 115 and the p-type layer 116 are grown on the side surface and the upper surface of the nanowire layer 114 by MOCVD. The active layer 115 has, for example, a multiple quantum well structure in which a GaInN quantum well layer having a thickness of 3 nm to 10 nm and a GaN barrier layer having a thickness of 5 nm to 20 nm are stacked five times. The p-type layer 116 may be a p-GaN layer having a positive hole concentration of 10¹⁸ atoms/cm⁻³ to 10¹⁹ atoms/cm⁻³. The nanowire core growth step illustrated in FIG. 9B, the inclined side surface portion growth step illustrated in FIG. 9C, and the growth step of the active layer 115 and the p-type layer 116 illustrated in FIG. 9D correspond to the columnar semiconductor layer growth step disclosed herein.

Growth conditions of the active layer 115 are the same as those of the active layer 15 according to the first embodiment.

Next, in the embedded layer formation step illustrated in FIG. 10E, the embedded layer 117 is formed to cover the side surfaces and the upper surfaces of the plurality of columnar semiconductor layers. Growth conditions of the embedded layer 117 in a case where the embedded layer 117 is formed of a p-type semiconductor layer are the same as the growth conditions of the embedded layer 18 according to the first embodiment.

Conditions of a source gas used for the growth of the embedded layer 117 such as a ratio, temperature, and pressure are the same as the conditions of the embedded layer 18 according to the first embodiment.

Next, in a mesa formation step illustrated in FIG. 10F, the embedded layer 117 to the underlying layer 112 are partially removed by selective dry etching to expose the upper surface of the underlying layer 112 and form the mesa groove. The mesa groove is formed to define a region surrounded by the mesa groove as a light emitting region of the semiconductor light emitting element 110.

Next, in an electrode formation step illustrated in FIG. 10G, the cathode electrode 118n is formed on the surface of the underlying layer 112 exposed in the mesa groove, and the anode electrode 118p is formed on the embedded layer 117. When necessary, annealing, forming of a passivation film, and element division are performed after the formation of the electrodes to obtain the semiconductor light emitting element 110.

In the semiconductor light emitting element 110 according to the present embodiment, when a voltage is applied between the cathode electrode 118n and the anode electrode 118p, a current flows through the embedded layer 117, the p-type layer 116, the active layer 115, the nanowire layer 114, and the underlying layer 112 in this order, and light is generated in the active layer 115 due to radiative recombination. Since the inclined side surface portion 114b and the active layer 115 are inclined with respect to the growth substrate 111, light emitted from the active layer 115 travels obliquely upward of the growth substrate 111, and an amount of light extracted in the main surface direction is increased.

Since the inclined side surface portion 114b of the nanowire layer 114 is a semipolar plane, the active layer 115 and the p-type layer 116 formed on an outer periphery of the inclined side surface portion 114b are also in contact with each other on the semipolar plane. Since the polarization of the semipolar plane is smaller than that of the c-plane, luminous efficiency in the active layer 115 is high, and since all the side surfaces of the hexagonal column are semipolar planes, luminous efficiency of the semiconductor light emitting element 110 can be improved. Further, since the film thickness of the active layer can be increased, the volume of the active layer 115 can be increased to substantially 3 times to 10 times as large as that of a semiconductor light emitting element in the related art, and an injected carrier density can be reduced to significantly reduce an efficiency droop.

As described above, in the semiconductor light emitting element 110 and the method for producing the semiconductor light emitting element 110 according to the present embodiment, since the side surface of the active layer 115 is inclined with respect to the main surface of the growth substrate 111, the light emitted from the active layer 115 is extracted obliquely upward of the growth substrate 111, and the amount of light extracted in the main surface direction can be increased. In addition, since the light emitted from the active layer 115 travels obliquely upward, the light absorbed by the other nanowire layers 114 can be reduced, and external quantum efficiency can be improved.

### (Fifth Embodiment)

Next, a fifth embodiment of the present disclosure will be described. Description of contents overlapping with the fourth embodiment will be omitted. In the fourth embodiment, the nanowire layer 114 is formed by two-stage growth in which conditions of the nanowire core growth step and the inclined side surface portion growth step are different. However, in the present embodiment, the nanowire layer 114 including the inclined side surface portion 114b is collectively formed.

In the present embodiment, after the mask formation step illustrated in FIG. 9A, the nanowire cores 114a and the inclined side surface portions 114b are continuously formed in the nanowire layer growth step under the same conditions. The growth condition of the nanowire growth step is a condition in which a V/III ratio of a raw material is lower or a growth temperature is lower compared with the growth conditions under which a side surface of an m-plane facet is formed in the nanowire core growth step.

The growth conditions under which the m-plane facet is formed are, for example: TMG and ammonia are used as source gases; a growth temperature is 1100°C; a V/III ratio is 20; and a pressure is 100 hPa using hydrogen as a carrier gas. Therefore, when the nanowire core 114a and the inclined side surface portion 114b are grown under one growth condition, the growth conditions include: a V/III ratio is set to 100 and a growth temperature is set to 1100°C; a V/III ratio is set to 20 and a growth temperature is set to 1000°C; and a V/III ratio is set to 100 and a growth temperature is set to 1000°C. By using such growth conditions, the nanowire core 114a and the inclined side surface portion 114b can be formed under one growth condition by simultaneously performing the upward growth from the opening 113a and the lateral growth in a region covering the mask 113 after the mask formation step illustrated in FIG. 9A.

The side surface of the nanowire layer 114 formed in the present embodiment also has a semipolar plane as in the fourth embodiment, and the active layer 115 and the p-type layer 116 are also formed to be inclined with respect to the main surface of the growth substrate 111. Accordingly, the polarization in the active layer 115 can be prevented to improve the luminous efficiency, and an amount of light extracted obliquely upward can be increased.

The present disclosure is not limited to the embodiments described above, and various modifications can be made within the scope of the claims. Embodiments obtained by appropriately combining technical techniques disclosed in different embodiments are also included in the technical scope of the present disclosure.

The present disclosure is based on Japanese Patent Application No. 2021-113350 filed on July 8, 2021 and Japanese Patent Application No. 2021-113883 filed on July 8, 2021, and the contents are incorporated herein by reference.

### INDUSTRIAL APPLICABILITY

The present disclosure can provide a semiconductor light emitting element and a method for producing a semiconductor light emitting element capable of increasing an amount of light extracted in a main surface direction and a back surface direction even in a case of a semiconductor light emitting element having a columnar semiconductor layer.

## Claims

1. A semiconductor light emitting element comprising:
a growth substrate;
a plurality of columnar semiconductor layers on the growth substrate;
a side surface reflection portion provided on a side surface of the columnar semiconductor layer and configured to reflect at least a part of light emitted from the columnar semiconductor layer; and
an embedded layer covering the columnar semiconductor layer and the side surface reflection portion.

2. The semiconductor light emitting element according to claim 1,
wherein the side surface reflection portion is a light reflection film in contact with the side surface of the columnar semiconductor layer.

3. The semiconductor light emitting element according to claim 2,
wherein the light reflection film is formed of a metal material containing any one of Al, Au, Ag, and Cr as a main component.

4. The semiconductor light emitting element according to claim 2,
wherein the light reflection film is formed of a semiconductor material having a band gap larger than a wavelength of the light, the light reflection film having an optical thickness larger than the wavelength of the light.

5. The semiconductor light emitting element according to claim 2,
wherein the light reflection film is a dielectric multilayer film containing any one of HfO₂, TiO₂, Ta₂O₅, Al₂O₃, SiO₂, and MgF₂.

6. The semiconductor light emitting element according to claim 1,
wherein the embedded layer is formed of a material having a refractive index different from that of the columnar semiconductor layer,
wherein the side surface of the columnar semiconductor layer has an inclined side surface inclined with respect to a main surface of the growth substrate, and
wherein the side surface reflection portion is formed of an interface between the inclined side surface and the embedded layer.

7. The semiconductor light emitting element according to any one of claims 1 to 6,
wherein the light of the side surface reflection portion has a reflectivity in a range of 30% to 90%.

8. The semiconductor light emitting element according to any one of claims 1 to 7,
wherein an upper surface reflection portion configured to reflect the light toward the growth substrate is formed on a surface of the embedded layer opposite to the growth substrate.

9. A method for producing a semiconductor light emitting element, the method comprising:
a columnar semiconductor growth step of forming a plurality of columnar semiconductor layers on a growth substrate;
a side surface reflection portion formation step of forming a side surface reflection portion on a side surface of the columnar semiconductor layer; and
an embedded layer formation step of forming an embedded layer to cover the columnar semiconductor layer.

10. A semiconductor light emitting element comprising:
a growth substrate;
a plurality of columnar semiconductor layers formed on the growth substrate; and
an embedded layer covering the columnar semiconductor layer,
wherein the columnar semiconductor layer comprises:
a nanowire layer;
an active layer disposed on an outer periphery of the nanowire layer; and
a p-type layer disposed on an outer periphery of the active layer, and
wherein a side surface of the active layer is inclined with respect to a main surface of the growth substrate.

11. The semiconductor light emitting element according to claim 10,
wherein the nanowire layer includes an inclined side surface portion which is a side surface inclined with respect to the main surface.

12. The semiconductor light emitting element according to claim 11, further comprising:
a mask on the growth substrate, the mask having an opening,
wherein the nanowire layer is selectively grown from the opening, and the inclined side surface portion is formed in a region partially covering the mask.

13. The semiconductor light emitting element according to any one of claims 10 to 12,
wherein the nanowire layer, the active layer, and the p-type layer are formed of a nitride semiconductor.

14. A method for producing a semiconductor light emitting element, the method comprising:
a columnar semiconductor growth step of forming a plurality of columnar semiconductor layers on a growth substrate; and
an embedded layer formation step of forming an embedded layer to cover the columnar semiconductor layer,
wherein the columnar semiconductor layer growth step comprises:
a nanowire layer growth step of forming a nanowire layer having an inclined side surface portion which is a side surface inclined with respect to a main surface of the growth substrate;
an active layer growth step of forming an active layer on an outer periphery of the inclined side surface portion; and
a p-type layer growth step of forming a p-type layer on an outer periphery of the active layer.

15. The method for producing the semiconductor light emitting element according to claim 14,
wherein the nanowire layer growth step comprises:
a nanowire core growth step of forming a nanowire core having a side surface perpendicular to the main surface of the growth substrate; and
an inclined side surface portion growth step of forming the inclined side surface portion on an outer periphery of the nanowire core.

16. The method for producing a semiconductor light emitting element according to claim 15,
wherein in the inclined side surface portion growth step, a V/III ratio of a raw material is set to be lower than that in the nanowire core growth step.

17. The method for producing a semiconductor light emitting element according to claim 15 or 16,
wherein in the inclined side surface portion growth step, a growth temperature is set to be lower than that in the nanowire core growth step.
